# EUROPÄISCHE PATENTANMELDUNG

(11) **EP 2 985 913 A1**
(43) Veröffentlichungstag der Anmeldung: **17.02.2016**
(21) Anmeldenummer: 15180098.4
(22) Anmeldetag: 07.08.2015
(51) Int. Cl.: H03K 17/96

(54) **BEDIENVORRICHTUNG MIT EINEM BLENDENTEIL UND ELEKTRISCHES GERÄT**

(30) Priorität: 13.08.2014 DE 102014111562
(71) Anmelder: Miele & Cie. KG, 33332 Gütersloh (DE)
(72) Erfinder: Schneider, Daniel, 33415 Verl (DE); Klausfering, Werner, 33415 Verl (DE); Evertzberg, Frank, 33428 Marienfeld (DE)

(57) **Zusammenfassung**

Die Erfindung betrifft eine Bedienvorrichtung (5) für ein elektrisches oder elektronisches Gerät (1), umfassend ein Blendenteil (6) mit Betätigungsflächen (7), einer Steuereinrichtung (4) und einer Anordnung von Sensoren (7), die jeweils den Betätigungsflächen (7) zugeordnet sind und dazu ausgebildet sind, eine elektrische Größe wie Kapazität oder Widerstand einer Schaltfläche zu erfassen zur Erkennung eines Bedienereignisses und als Schaltsignal zur Auswertung der Schaltposition der Steuereinrichtung (4) zuzuführen.
Um auf einfache Weise die Bedienung zuverlässiger zu gestalten, ist die Bedienvorrichtung mit zumindest einem Aktor (9) versehen, der dazu ausgebildet ist, die Blende (6) mit zumindest einem einen Kraftimpuls zu beaufschlagen, derart, dass ein erster Kraftimpuls zu Beginn des Bedienereignisses und ein zweiter Kraftimpuls bei Beendigung des Bedienereignisses auf die Blende einwirkt.

Die Erfindung betrifft ferner ein Elektrisches Gerät (1), wie Gargerät (1), Getränkebereiter, Waschmaschine, Trockner, Geschirrspüler oder Desinfektionsgerät, umfassend eine Bedieneinrichtung (5) wie vorstehend genannt, die mit einer Steuereinrichtung (4) in Wirkverbindung steht zur Einstellung und zum Betreiben des elektrischen Gerätes (1).

## Beschreibung

Die Erfindung betrifft eine Bedienvorrichtung für ein elektrisches oder elektronisches Gerät, umfassend ein Blendenteil mit Betätigungsflächen, einer Steuereinrichtung und einer Anordnung von Sensoren, die jeweils den Betätigungsflächen zugeordnet sind und dazu ausgebildet sind, bei Berührung oder Kraftbeaufschlagung einer Schaltfläche oder bei Annäherung an eine Schaltfläche eine elektrische Größe wie beispielsweise Kapazität, Widerstand, Strom oder Spannung zu erfassen und als Schaltsignal zur Auswertung der Schaltposition der Steuereinrichtung zuzuführen.

Elektrische Geräte, wie Haushaltgeräte oder gewerbliche Waschmaschinen oder gewerbliche Trockner besitzen eine Bedienvorrichtung, die besonders robust aufgebaut und einfach zu bedienen ist. Dabei sind besonders Bedienvorrichtungen mit Tasten oder Berührflächen beliebt, da sie eine aufgeräumte Blende ermöglichen mit einer übersichtlichen Anzahl an Bedienmöglichkeiten. Bei besonders robust ausgebildeten Geräten kommen Blenden aus Edelstahl zum Einsatz, die besonders einfach zu reinigen sind und daher auch gewisse Hygieneanforderungen erfüllen.

So ist aus der EP 1 641 010 A1 eine Bedienvorrichtung für ein elektrisches Gerät bekannt, die Schaltflächen umfasst, die durch eine Kraftbeaufschlagung mit einem innerhalb der Bedienvorrichtung angebrachten Sensoren derart zusammenwirkt, dass eine Betätigung entsprechend sensiert wird. Hierbei kann es vorkommen, dass der Bediener eine Verformung der Blendenoberfläche entweder nicht wahrnimmt und somit durch mehrmalige Betätigungen das elektrische Gerät fehlbedient oder dass eine spürbare Verformung oder Verwindung der Bedienfläche bzw. der Blende als unangenehm empfunden wird.

Eine Bedienvorrichtung mit Betätigungsflächen als Berührflächen ist aus der DE 10 2007 026 857 A1 bekannt. Hierbei ist im Blendenteil eine Leiterplatte mit den Kontaktflächen bzw. Sensoren angeordnet, die mittels Federn an der Innenseite des Blendenteils elektrisch verbunden sind. Eine Berührung bzw. Annäherung an der jeweils außenseitigen Berührfläche führt zu einer Kapazitätsänderung des Sensors, die entsprechend als Schaltvorgang erfasst und weiterverarbeitet wird.

Aus der US 2013/00229088 A1 ist ein mobiles Eingabegerät mit einer berührsensitiven Bedienfläche bekannt, die eine akustische oder haptische Rückmeldung bietet. Hierbei ist an der Innenseite der Bedienblende ein Vibrationsgeber angebracht, der bedarfsweise eine Vibration auf die Blende einkoppelt und dadurch eine haptische oder taktile Rückmeldung gibt.

Der Erfindung liegt somit die Aufgabe zu Grunde, eine Bedienvorrichtung für ein elektrisches Gerät zu schaffen, die bei einfachem Aufbau sicher und zuverlässig funktioniert und die eine gute Haptik dem Benutzer vermittelt.

Erfindungsgemäß wird zumindest diese Aufgabe durch eine Bedienvorrichtung mit den Merkmalen des unabhängigen Anspruchs 1 und durch ein elektrisches Gerät gemäß dem unabhängigen Anspruch xx gelöst. Vorteilhafte Ausgestaltungen und Weiterbildungen der Erfindung ergeben sich aus den jeweils nachfolgenden abhängigen Ansprüchen.

Ein relevanter Vorteil besteht darin, dass dem Bediener eine bewusste Bedienhandlung zur Betätigung einer Schaltfläche abverlangt wird. Fehlbedienungen aufgrund einer zufälligen Berührung einer berührsensitiven Schaltfläche können nicht mehr vorkommen. Ferner kann die Darbietung von Bedienhandlungen dahingehend verbessert werden, dass bei Berührung der Schaltfläche das Bedienereignis als gültig angesehen wird und dem Benutzer unmittelbar eine taktile Rückmeldung in Form eines Bewegungsimpulses auf die Blende gegeben wird. Durch den zweiten Impuls, der auf die Bedienblende eingekoppelt wird, wenn das Bedienereignis beendet wird, kann das Zurückspringen eines Tasters als taktiles Erlebnis vermittelt werden. Der Benutzer hat somit trotz Touch-Bedienung das Gefühl, einen Taster zu betätigen, wodurch ihm das sichere Gefühl vermittelt wird, dass die gewünschte Betätigung auch stattgefunden hat. Dies wird auf einfache Weise dadurch erreicht, dass die Bedienvorrichtung zumindest einen Aktor umfasst, der dazu ausgebildet ist, die Blende mit zumindest einem einen Kraftimpuls zu beaufschlagen, derart, dass ein erster Kraftimpuls zu Beginn des Bedienereignisses und ein zweiter Kraftimpuls bei Beendigung des Bedienereignisses auf die Blende einwirkt. Der Kraftimpuls ist dabei vorzugsweise so ausgebildet, dass er senkrecht oder zumindest nahezu senkrecht zur Erstreckung der Fläche der Bedienblende auf oder in die Blende eingekoppelt wird.

Die erfindungsgemäße Anordnung kann für alle üblichen Touch-Blenden zum Einsatz kommen, beispielsweise bei denen es bei einer Betätigung durch Berührung oder Annäherung zu einer Kapazitätsänderung kommt (kapazitive Sensoren) oder bei denen es bei einer Betätigung zu einer Veränderung z.B. des Photostromes kommt (optische Sensoren oder bei denen es bei einer Betätigung zu einer Änderung der Induktivität kommt (induktive Sensoren).

In einer vorteilhaften Weiterbildung ist ein optischer oder akustischer Hinweis über diese Anwahl erfolgt, wobei erst bei der bewussten Druckausübung auf die entsprechende Schaltfläche die Anwahl zur Ausführung in der Steuereinrichtung übernommen wird bzw. die angewählte Aktion gestartet wird. Die wird auf einfache Weise durch zumindest einen weitern Sensor erreicht, der dazu ausgebildet ist, eine Kraftbeaufschlagung auf die Blende bzw. einer der jeweiligen Betätigungsfläche zu erfassen und als weiteres Signal der Steuereinrichtung zuzuführen zu einer zusätzlichen Bewertung des Bedienereignisses. Im einfachsten Fall reicht ein einziger Sensor aus, um einen Druck auf eine beliebige von mehreren Schaltflächen als Bedienereignis zu erfassen bzw. als solches zu beurteilen. Die Bedienblende ist dabei als Touchblende, mit Touchflächen oder als Touchscreen, ausgebildet, wobei die Auswertung und Erkennung der Berührstelle auf die bereits bewährte Art und Weise erfolgt. Aufgrund der Kombination aus Druckbetätigung mit der zuvor erläuterten taktilen Rückmeldung wird ein sicheres Bedienereignis und Bedienerlebnis geboten.

In einer zweckmäßigen Ausführung ist der zusätzliche Sensor zumindest ein Kraftsensor, der dazu geeignet und ausgebildet ist, eine Kraftbeaufschlagung auf der Außenseite des Blendenteils zu erfassen. Dabei kann auch ein Wegsensor verwendet werden, der eine entsprechende Ortsveränderung der Blende bei Druckbeaufschlagung durch den Betätigungsdruck erfasst und als Signal der Steuereinrichtung zur Auswertung des Bedienereignisses zuführt.

In einer insgesamt vorteilhaften Ausführung weist das Blendenteil Mittel zur schwimmenden Lagerung oder Kopplung an einem Gehäuse des elektrischen Gerätes auf. Damit ist eine definierte Bewegung, insbesondere eine Hubbewegung der Blende sichergestellt, die eine sicherere Erfassung eines Drucks auf die Blende ermöglicht.

In einer vorteilhaften Weiterbildung ist als Mittel zur schwimmenden Lagerung eine elastische Dichtung zur Anlage des Blendenteils an dem feststehenden Gehäuse des Gerätes vorgesehen. Damit wird gleichzeitig eine Abdichtung des Blendenteils zum Gehäuse bereitgestellt. Als Dichtung kann dabei ein umlaufender Elastomerring verwendet werden oder eine zwischen Gehäuse und Blende verlaufende Fuge eingespritzte Dichtmasse, beispielsweise Silikon oder Acryl.

Alternativ oder in Kombination dazu sind in einer weiteren Ausführung als Mittel zur schwimmenden Lagerung federnde Befestigungselemente, beispielsweise Schraubfedern oder Blattfedern aus Metall, vorgesehen. Federn aus Metall sind hinsichtlich der Bereitstellung von Bewegungen oder einer schwimmenden Lagerung reaktionsschnell und altersbeständig.

In einer weiteren oder alternativen Ausführung ist das Blendenteil als verformbare Platte ausgebildet. Dadurch ergibt sich partielle Verformung bei Kraftbeaufschlagung auf die Außenfläche der Blende, die mit dem Kraftsensor oder Wegsensor sensiert werden kann.

Insgesamt ist es vorteilhaft, die Verformbarkeit bzw. Bewegung des Blendenteils senkrecht zur Außenfläche des Blendenteils in einem Bereich von 0,2 mm bis 2 mm vorzusehen. Damit wird sichergestellt, dass der Benutzer ein Eindrücken der Blende in Richtung Gehäuseinneres deutlich als taktiles Erlebnis wahrnimmt.

Es ist insgesamt zweckmäßig, dass der Kraftsensor an der Blende angekoppelt und ferner zur Kopplung mit dem ortsfesten Gehäuse des Gerätes ausgebildet ist, um in betriebsgemäßem Zustand eine Verformung oder Bewegung der Blende in Richtung Tastflächenbetätigung, also quer zur Erstreckung der Außenfläche der Blende , zu erfassen. Als betriebsgemäßer Zustand ist der im Gerät eingebaute Zustand der Blende bzw. der Bedieneinrichtung in betriebsgemäßer Lage des elektrischen Gerätes anzusehen.

In einer insgesamt vorteilhaften Weiterbildung der Erfindung oder der genannten Ausführungen ist der weitere Sensor dazu ausgebildet, eine Verformung oder Bewegung der Blende beim Eindrücken und eine entgegengesetzte Bewegung oder Verformung der Blende beim Loslassen zur Bestimmung des Bedienereignisses zu erfassen. Damit können Bedienabläufe oder Bedienhandlungen, wie sie mit Tastschaltern möglich sind, auf einfache Weise nachempfunden werden.

Um die Druckerfassung sicher bereitzustellen, ist es zweckmäßig, dass der Kraftsensor rückseitig im mittleren Bereich mit der Blende gekoppelt oder befestigt ist, bezogen auf die Erstreckung der Blende von einem seitlichen Ende zum gegenüberliegendem seitlichen Ende der Blende.

In einer weiteren insgesamt vorteilhaften Ausführung ist der Aktor rückseitig an einem seitlichen Ende der Blende und ein weiterer Aktor rückseitig am gegenüberliegenden, seitlichen Ende der Blende gekoppelt oder befestigt. Damit kann die Blende homogen quer zur Erstreckung der Blendenebene bewegt werden, Schwenkbewegungen oder sonstige Verwindungen der Blende werden vermieden.

In einer insgesamt vorteilhaften Ausführung der Erfindung umfasst die Bedienvorrichtung ein akustisches Ausgabemittel welches dazu ausgebildet ist, ein akustisches Signal im erfassten Betätigungsfall auszugeben. Damit wird das Betätigungserlebnis nochmals verstärkt, wenn zusätzlich zu spürbaren Impuls auf den Finger beispielsweise ein "Klick"- Geräusch oder anderes signifikantes Betätigungsgeräusch erzeugt und vom Bediener vernommen wird.

Die Erfindung betrifft auch ein Sensor-Aktor Modul, geeignet zum Einsatz in einer Bedienvorrichtung wie vorstehend beschrieben, welches als integrale Einheit ausgebildet ist, umfassend ein Gehäuse ausgebildet zur Befestigung an der Blende oder dem Gehäuse und einem Stößel zur Übertragung der Bewegung zwischen Blende und Sensor-Aktor-Modul. Aufgrund der Zusammenlegung von Sensor und Aktor ist dieses Modul bei der Montage der Bedienvorrichtung bzw. beim Einbau in das elektrische Gerät sehr einfach zu handhaben. Ferner sind keine Feinjustierungen oder Kalibrationen notwendig, da sich Sensor und Aktor stets in vordefinierter Position zueinander befinden. Toleranzen, die sich aufgrund der Gehäusefertigung oder Blendenfertigung nicht vermeiden lassen, erfordern hierbei keinerlei Nachjustierung des Sensors oder Aktors.

In einer vorteilhaften Weiterbildung des Moduls umfasst der Aktor einen Elektromagneten mit einem Hubanker, und ferner einen mit dem Hubanker gekoppelten Kraft- oder Wegsensor zur Erfassung einer auf den Hubanker eingekoppelten Bewegung oder Druck besitzt. Dadurch, dass ein einziges bewegliches Teil sowohl für die Anregung der Bewegung als auch für die Erfassung der Bewegung zuständig ist, können komplizierte und verschleißanfällige Übertragungsmittel entfallen. Ferner ist ein stets gleichbleibendes, definiertes Verhalten von Aktor und Sensor sichergestellt.

Insgesamt ist vorteilhaft, die eingangsgenannte und erläuterte Bedienvorrichtung mit einem solchen, eben genannten Sensor-Aktor-Modul zu versehen, um eine sichere und optimale Funktion bereitzustellen.

Die Erfindung betrifft ferner ein Elektrisches Gerät, wie Gargerät, Getränkebereiter, Waschmaschine, Trockner, Geschirrspüler oder Desinfektionsgerät, umfassend eine Bedieneinrichtung wie vorstehend beschrieben, die mit einer Steuereinrichtung in Wirkverbindung steht zur Einstellung und zum Betreiben des elektrischen Gerätes. Dabei kann der Sensor zur Erfassung einer Krafteinwirkung am Gehäuse des Gerätes befestigt werden, wobei mit Hilfe eines Kopplungsmittels oder mechanischen Übertragungsmittels die Kopplung zur Innenseite der Blende erfolgt.

Ein Ausführungsbeispiel der Erfindung ist in den Zeichnungen rein schematisch dargestellt und wird nachfolgend näher beschrieben. Es zeigen
- Fig. 1: als elektrisches Gerät ein Gargerät bzw. Backofen
- Fig. 2: eine Bedienblende in einer Detailansicht;
- Fig. 3:: die Bedienblende in einer skizzierten Ansicht von der Innenseite;
- Fig. 4:: beispielhaft den Ablauf einer Bedienhandlung als Diagramm und
- Fig. 5:: den Sensor und den Aktor als modulare Einheit.

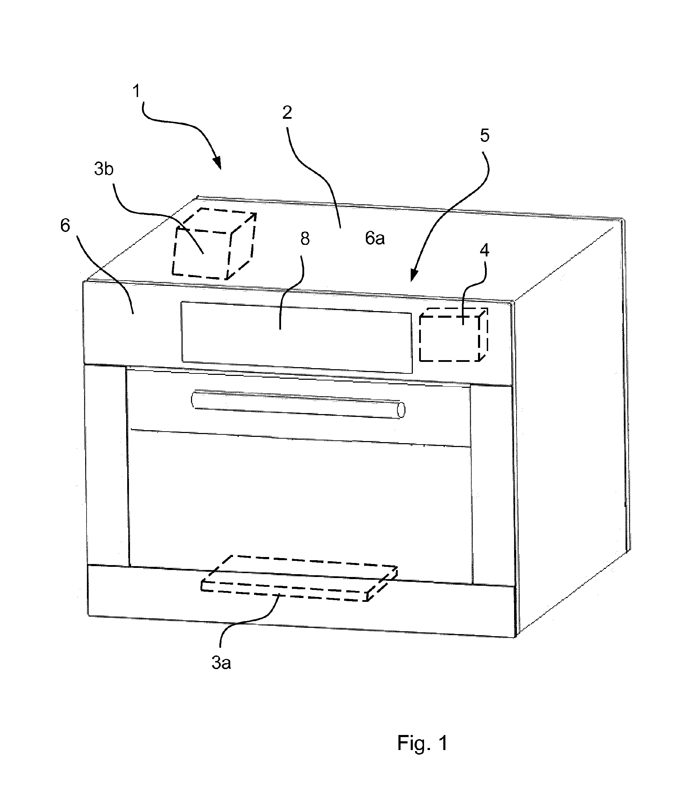

Das elektrische Gerät 1 gemäß Fig. 1 umfasst in diesem Beispiel Gehäuse 2 und die elektrisch betriebenen Komponenten 3 und eine Steuereinrichtung 4 zum Betrieb des Gerätes. 1 Hierbei handelt es sich um einen Backofen, der als Einbaugerät ausgeführt ist, sodass die Steuereinrichtung 4 anhand von Benutzereingaben zur Durchführung eines Garprogramms die elektrischen oder elektronischen Komponenten bzw. Lasten 3, wie Heizkörper 3a, Gebläse 3b oder Mikrowellensender 3c entsprechend aktiviert oder deaktiviert. Das elektrische Gerät 1 umfasst ferner eine Bedienvorrichtung 5, die eine für den Benutzer zugängliche Blende 6 mit daran angeordneten Schaltflächen bzw. Betätigungsflächen 7 umfasst. Der Benutzer kann durch Betätigung der Schaltflächen 7 vorbestimmte Programme, wie sogenannte automatische Garprogramme oder Parametereinstellungen vornehmen, die dann von der Steuereinrichtung 4 entsprechend verarbeitet werden. In dem gezeigten Beispiel ist die Bedienvorrichtung 5 mit einer senkrechten Blende 6 versehen, die im vorderen oberen Bereich des Gerätes 1 bzw. Gerätegehäuse 2 angebracht ist. Die Blende 6 kann alternativ oder kombiniert als schräge oder bombierte Blende 6 im oder am Gehäuse 2 angeordnet werden.

Die Steuereinrichtung 4 wirkt hierbei mit der Bedieneinrichtung 5 zusammen bzw. kann Bestandteil der Bedieneinrichtung 5 sein, da zur Auswertung der Bedienhandlung die Steuereinrichtung 4 verwendet wird. Alternativ kann die Bedieneinrichtung 5 eine separate Steuerung mit eigenem Mikrocontroller enthalten, der mit der Gerätesteuerung 4 zusammenwirkt bzw. mit dieser in Kommunikationsverbindung steht.

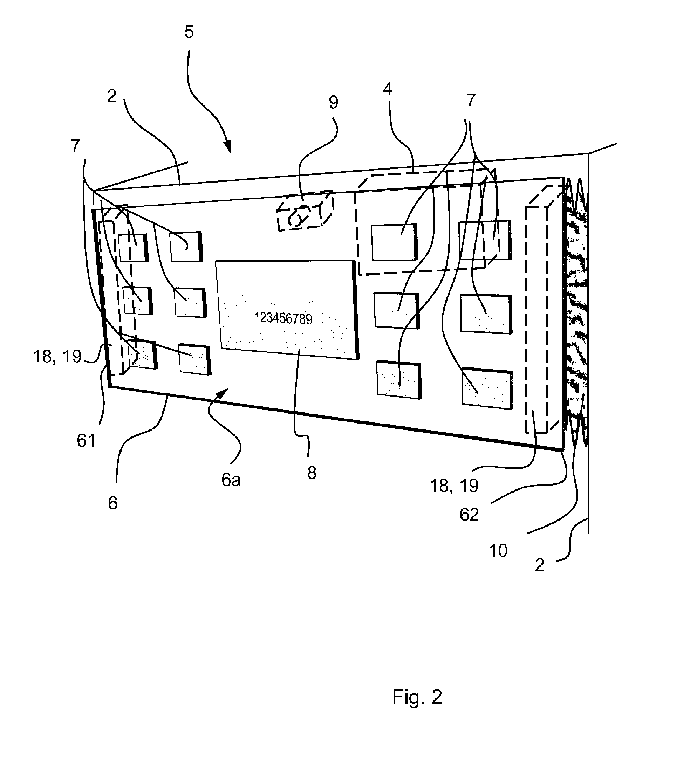

Fig. 2 zeigt in einer Detailansicht die Bedienvorrichtung 5, die die Blende 6 mit den Tastflächen 7 und einem Display 8 zeigt. Die Blende 6 ist dabei am Gehäuse 2 angebracht und ist ferner rückseitig, also gegenüberliegend der Außenfläche 6a, mit einem Sensor 9. hier einem Kraftsensor oder einem Wegsensor, gekoppelt. Mit diesem Sensor 9 wird an zentraler Stelle der Blende eine Bewegung der Blende 6 in Richtung einer Tastflächenbetätigung erfasst. Um eine Bewegung in eng begrenztem Maße bereitzustellen, ist die Blende 6 mit einem elastischen Mittel 10 an dem ortsfesten Gerätegehäuse 2 angebracht.

Alternativ kann die Befestigung der Blende mittels federnder Bauelemente, beispielsweise Schraubenfedern oder Blattfedern, erfolgen. Das Entspannen von metallischen Federn erfordert in der Regel geringere Zeiten gegenüber Kunststoffkomponenten, sodass eine sehr zuverlässige und dauerhaft funktionierende Anordnung geschaffen wird.

Damit kann das gesamte Blendenteil 6 etwas in Richtung D der Tastenbetätigung bewegt werden, vorzugsweise ist der Bewegungsbereich auf einen Wert von 0,2 mm bis 2 mm begrenzt, sodass die schwimmende Anbindung an das Gehäuse 2 vom Benutzer nur gering wahrnehmbar ist bzw. nur bei einer Bedienhandlung. Der Sensor 9 ist in dieser Ansicht von der Blende 6 verdeckt, da er oben - mittig hinter der Blende 6 liegt. Der Sensor 9 ist dabei am Gerätegehäuse 2 und an der Blende 6 gekoppelt oder befestigt, um eine Relativbewegung der Blende 6 zum Gehäuse 2 zu erfassen. In einer bevorzugten Ausführung ist die Blende 6 mit einem Display 8 zur Anzeige von Informationen oder Gerätezuständen versehen.

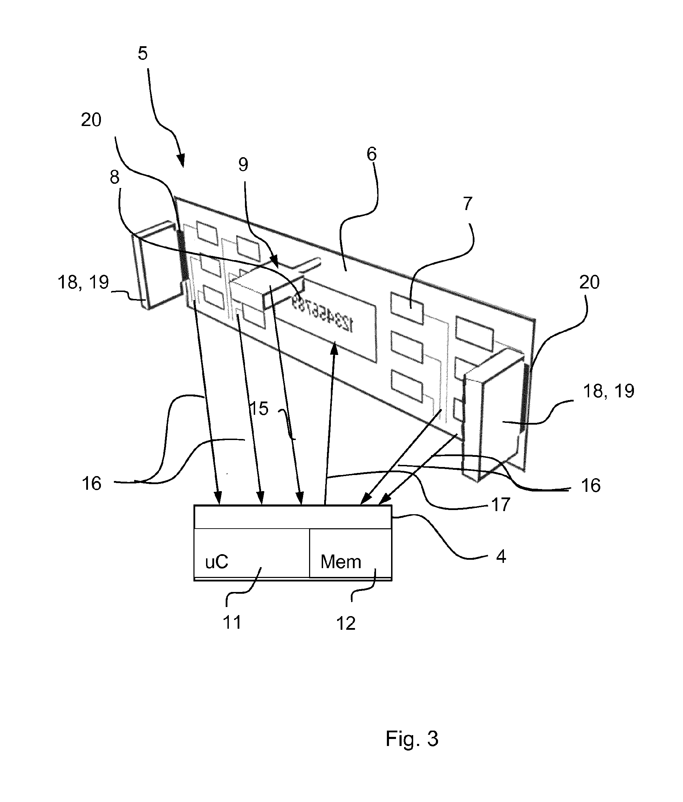

Fig. 3 zeigt die Bedienvorrichtung 5 mit der Blende 6 von der Rückseite oder Innenseite. Die Blende 6 ist mit einer leitfähigen Beschichtung 7b versehen, um die berührsensitiven Schaltflächen bereitzustellen und bei Berührung eine Änderung des elektrischen Widerstandes, Strom, Spannung oder Kapazität zu bewirken, die wiederrum von der Steuereinrichtung 4 erfasst und entsprechend ausgewertet wird. Es kann alternativ auch ein Berührbildschirm, auch Touch-Screen genannt, an der Blende 6 angeordnet werden oder die Blende selbst bilden. Die Steuereinrichtung 4 umfasst dabei vorzugsweise einen Mikrocontroller 11 mit einem Speicher 12, um die Bedienfunktionen oder zusätzlich Gerätefunktionen bzw. Anzeigefunktionen für das Display 8 bereitzustellen. Der weitere Sensor 9, der die Kraftbeaufschlagung auf der Blende 6 erfasst, ist signaltechnisch, angedeutet mit dem Pfeil 15, mit der Steuereinrichtung 4 verbunden, sodass aus der Kombination, beispielsweise einer logischen UND-Verknüpfung, aus der erfassten Berührung einer Berührfläche 7 mit der globalen Druckbeaufschlagung die Entscheidung über das Bedienereignis durch die Steuereinrichtung 4 bzw. dem programmierten Mikrocontroller 11 getroffen wird. Die Pfeile 16 skizzieren die Signalverbindungen oder Leitungen zwischen den Berührsensitiven Flächen 7 bzw. den leitfähigen Schichten 7b und der Steuereinrichtung 4 bzw. dem Mikrocontroller 11. Ferner ist mit dem weiteren Pfeil 17 die Signal oder Datenverbindung zum Display oder einer Anzeigeeinrichtung skizziert, wobei die reale Datenverbindung in der Regel eine Mehrzahl von Leitungen umfasst. Die Bedienvorrichtung 5 umfasst ferner zumindest einen Aktor 18, der eine Hubbewegung bzw. mechanische Anregung oder haptisch spürbare Anregung auf die Blende 6 bewirkt, wenn dieser von der Steuereinrichtung 4 entsprechend angesteuert oder aktiviert wird. In dem in Fig. 3 oder Fig. 2 dargestellten Beispiel sind zwei Aktoren 18 mit der Blende 6 gekoppelt, wobei der erster Aktor 18 am linken seitlichen Ende 61 und der zweite Aktor 18 am rechten, seitlichen Ende 62 der Blende 6 gekoppelt oder befestigt ist. Damit übernehmen die Aktoren 18 auch die Funktion der Anbindung der Blende 6 am Gehäuse 2. Die Aktoren selbst umfassen ein Gehäuse 19, welches die funktionalen Komponenten aufnimmt und das Mittel zur Befestigung am Gehäuse 2 aufweist.

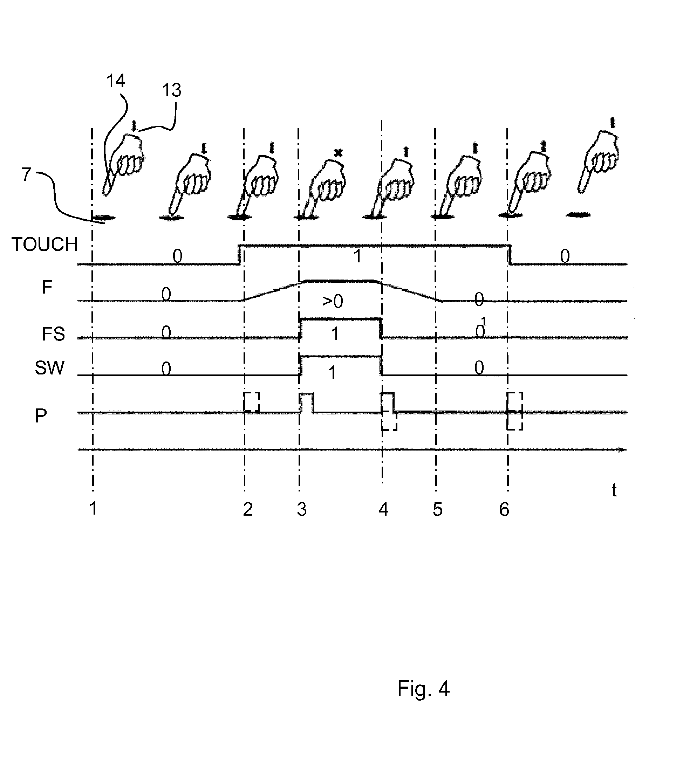

Fig. 4 zeigt als Diagramm beispielhaft den Ablauf einer Betätigung einer Schaltfläche 7 mit den einzelnen Signalen aufgrund der Auswertung dazu. Zum Zeitpinkt t=1 ist der Finger 14 des Benutzers von der Blende 6 bzw. von der Berührfläche 7 entfernt. Mit dem Pfeil 13 ist angedeutet, dass der Finger 14 sich in Richtung Berührfläche oder Betätigungsfläche 7 bewegt. Ab dem Zeitpunkt t=2 berührt der Finger die ausgewählte Fläche 7, sodass das Berührsignal TOUCH aktiv wird. Ferner ist zu erkennen, dass sich ab dem Zeitpunkt t=2 die Kraftbeaufschlagung F auf die Blende 6 erhöht. Bei Errechnen eines vorbestimmten Grenzwertes zum Zeitpunkt t=3 wird eine Kraftbeaufschlagung bzw. die Schwelle oder Grenzwert für die Beurteilung einer Kraftbeaufschlagung durch den Sensor 9 erkannt und als Signal FS der Steuereinrichtung 4 zugeführt. Diese wiederrum erkennt das Bedienereignis SW aus der logischen UND-Verknüpfung des Sensorsignals FS und dem individuell der jeweiligen Schaltfläche 7 zugeordneten Touch-Signal TOUCH. Bei oder nach der Erkennung des Bedienereignisses SW wird auch der Impuls P auf den Aktor ausgegeben, der eine Hubbewegung bzw. mechanische Anregung oder haptisch spürbare Anregung auf der Blende 6 verursacht. Ab dem Zeitpunkt t=4 wird der Druck auf die Schaltfläche 7 nachgelassen, also der Tastvorgang wird beendet. Zu erkennen ist, dass die Kraftbeaufschlagung F auf die Außenfläche 6a der Blende 6 stetig nachlässt oder absinkt. Das vom Sensor 9 generierte Sensorsignal FS nimmt dabei wieder den Zustand 0, also deaktiviert ein. Auch das Schaltsignal SW wird ab dem Zeitpunkt t=4 deaktiviert, wodurch das allmähliche Loslassen eines normalen federbelasteten Tasters nachempfunden wird. Bei oder nach der Deaktivierung des Schaltsignals SW wird erneut der Impuls P auf den Aktor ausgegeben, der eine Hubbewegung bzw. mechanische Anregung oder haptisch spürbare Anregung auf der Blende 6 verursacht und dadurch dem Bediener ein Eispringen eines Tasters in die Ausgangslage suggeriert. Ab dem Zeitpunkt t=5 ist die Kraftbeaufschlagung F auf die Außenfläche 6a der Blende 6 beendet, wobei der Finger 14 noch auf der Tastfläche 7 aufliegt. Das Signal TOUCH der berührsensitiven Auswertung ist noch weiterhin aktiv bis zum Zeitpunkt t=6. Ab diesem Zeitpunkt liegt der Finger 14 nicht mehr auf der Berührfläche 7, sodass das Signal TOUCH deaktiviert bzw. auf 0 gesetzt wird. Der Schaltvorgang oder das Schalt- oder Tastereignis ist jedoch schon bei t=4 beendet. Die gestrichelten Pulse auf dem Graphen P zeigen eine alternative Ausführungsform, bei der der Puls bei Erkennung der Berührung zum Zeitpunkt

t=2 auf die Blende eingesteuert wird und unmittelbar beim Abheben des Fingers 14 von der Berührfläche 7 zum Zeitpunkt t=6. Der zweite Puls kann auch in die entgegengesetzte Richtung zum ersten Impuls aktiviert werden, sodass bei Eindrücken die Blende 6 mit einem einen Kraftimpuls P nach innen, also in Druckrichtung beaufschlagt wird und beim loslassen einen Kraftimpuls P nach außen, also entgegengesetzt zum Betätigungsrichtung beaufschlagt wird. Damit kann die Blende von einer mittlerer Ruhelage heraus sowohl zum Gehäuseinneren als auch zum Gehäuseäußeren bewegt werden, sodass die Anbindung an das Gehäuse 2 und der Aktor 18 entsprechend ausgebildet ist, diese beiden Bewegungsrichtungen zuzulassen.

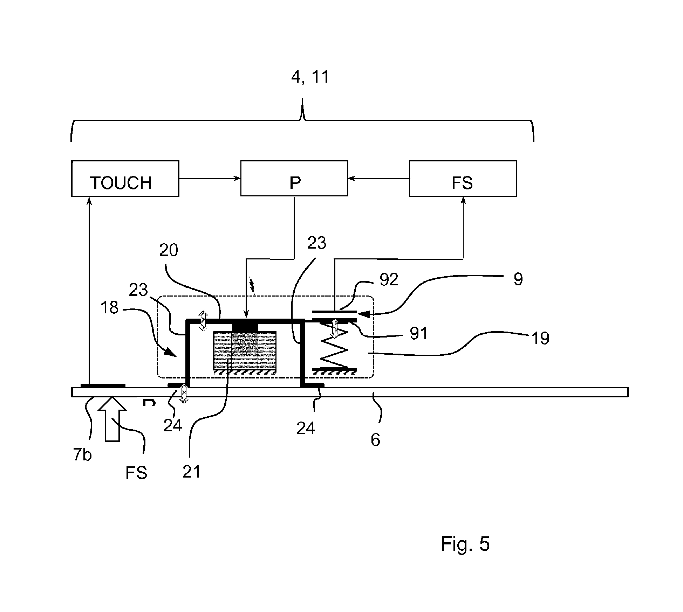

Fig. 5 zeigt im Detail eine bevorzugte Ausführung des Sensors 9 und Aktors 18, die als integrales Modul 19 zusammengefasst sind. Das Modul 19 umfasst ein Gehäuse, in dem sowohl der Sensor 9 als auch der Aktor 18 untergebracht sind. Der Aktor 18 ist hierbei als Elektromagnet bzw. Hubmagnet mit einer Spule 21 und einem gegenüber dem Gehäuse 19 beweglichen Anker 20 ausgebildet. Der Anker 20 ist mit einer Elektrode 91 mechanisch gekoppelt, die mit einer Gegenelektrode 92 in Beziehung steht und bei Bewegung eine elektrische Größe als Sensorsignal generiert oder verändert. Damit wird der Sensor 9 gebildet. Der Anker 20 umfasst ferner Stützschenkel 23, die aus dem Gehäuse 19 austreten und durch Abkantungen 24 eine flanschähnliche Befestigungsmöglichkeit bieten. Die flanschähnlichen Abkantungen 24 können an der Innenseite der Blende 6 befestigt werden, bzw. sind dazu geeignet, die Kopplung mit der Blende 6 bereitzustellen. Zu erkennen ist in Fig. 5 ferner die Tastfläche 7b, die mit Hilfe des funktionalen Auswerteblocks TOUCH überwacht und eine Berührung erfasst wird. Die Überwachung der Krafteinwirkung F auf die Blende erfolgt mit Hilfe des Funktionsblocks FS. Die Aktivierung des Aktors 18 bzw. der Magnetspule 21 wird durch den Funktionsblock P bereitgestellt. Die genannten Funktionsblöcke werden durch den Mikrocontroller 11 im Zusammenspiel mit dem im Speicher 12 abgelegten Programm der Steuereinrichtung 4 bereitgestellt. Bei diesem beispielhaften Aufbau ist die am Flansch 24 bzw. Anker 20 des Aktors 18 fixierte Bedienblende 6 zum Gehäuse 19 des Aktors 18 beweglich. Eine Veränderung der Lage der Blende 6 zum fest am Gerät montierten Aktor 18 führt gleichzeitig zu einer Veränderung des Abstandes zwischen der beweglichen Elektrode 91 und der dazu zugeordneten, festen Elektrode 92.

## Patentansprüche

1. Bedienvorrichtung (5) für ein elektrisches oder elektronisches Gerät (1), umfassend ein Blendenteil (6) mit Betätigungsflächen (7), einer Steuereinrichtung (4) und einer Anordnung von Sensoren (7), die jeweils den Betätigungsflächen (7) zugeordnet sind und dazu ausgebildet sind, bei Berührung oder Kraftbeaufschlagung einer Schaltfläche (7) oder bei Annäherung an eine Schaltfläche (7) eine elektrische Größe wie beispielsweise Kapazität, Widerstand, Strom oder Spannung zu erfassen und als Schaltsignal zur Auswertung der Schaltposition der Steuereinrichtung (4) zuzuführen, **gekennzeichnet durch**
zumindest einen Aktor (18), der dazu ausgebildet ist, die Blende (6) mit zumindest einem Kraftimpuls zu beaufschlagen.

2. Bedienvorrichtung (5) nach Anspruch 1,
**dadurch gekennzeichnet**
**dass** der Aktor (18) mittels der Steuereinrichtung (4) aktivierbar ist und dazu ausgebildet ist, einen erster Kraftimpuls zu Beginn des Bedienereignisses und einen zweiter Kraftimpuls bei Beendigung des Bedienereignisses auf die Blende (6) bewirken.

3. Bedienvorrichtung (5) nach Anspruch 1 oder 2,
**gekennzeichnet durch**
zumindest einen weiteren Sensor (9), der dazu ausgebildet ist, eine Kraftbeaufschlagung (F, FS) auf die Blende (6) bzw. auf eine der jeweiligen Betätigungsfläche (7) zu erfassen und als weiteres Signal (FS) der Steuereinrichtung (4) zuzuführen zu einer zusätzlichen Auswertung bzw. Erkennung des Bedienereignisses (SW).

4. Bedienvorrichtung (5) nach Anspruch 3,
**dadurch gekennzeichnet**
**dass** der zusätzliche Sensor (9) zumindest ein Kraftsensor ist, der dazu geeignet und ausgebildet ist, eine Kraftbeaufschlagung (F, FS) auf der Außenseite (6a) des Blendenteils (6) zu erfassen.

5. Bedienvorrichtung (5) nach Anspruch 3,
**dadurch gekennzeichnet**
**dass** der zusätzliche Sensor (9) zumindest ein Wegsensor ist, der dazu geeignet und ausgebildet ist, bei Krafteinwirkung auf der Außenseite (6a) des Blendenteils (6) eine Lageänderung oder Verformung der Blende (6) zu erfassen

6. Bedienvorrichtung (5) nach einem der Ansprüche 1 bis 5,
**dadurch gekennzeichnet, dass** das Blendenteil (6) Mittel (10) zur schwimmenden Lagerung oder Kopplung an einem Gehäuse (2) des elektrischen Gerätes (1) aufweist.

7. Bedienvorrichtung (5) nach Anspruch 6,
**dadurch gekennzeichnet, dass** als Mittel (10) zur schwimmenden Lagerung eine elastische Dichtung zur Anlage des Blendenteils (6) an dem feststehenden Gehäuse (2) des Gerätes (1) vorgesehen ist.

8. Bedienvorrichtung (5) nach Anspruch 6,
**dadurch gekennzeichnet, dass** als Mittel (10) zur schwimmenden Lagerung federnde Befestigungselemente vorgesehen sind

9. Bedienvorrichtung (5) nach einem der Ansprüche 1 bis 8,
**dadurch gekennzeichnet,**
**dass** die Verformbarkeit bzw. Bewegung des Blendenteils (6) senkrecht zur Außenfläche (6a) des Blendenteils (6) im Bereich von 0,2 mm bis 2 mm liegt.

10. Bedienvorrichtung (5) nach einem der Ansprüche 1 bis 9,
**dadurch gekennzeichnet,**
**dass** der Kraftsensor (9) oder Wegsensor an der Blende (6) angekoppelt ist und ferner zur Kopplung mit dem ortsfesten Gehäuse (2) des Gerätes (1) ausgebildet ist, um im betriebsgemäßen Zustand eine Verformung oder Bewegung der Blende (6) in Richtung Tastflächenbetätigung, also senkrecht zur Erstreckung der Außenfläche (6a) der Blende (6), zu erfassen.

11. Bedienvorrichtung (5) nach Anspruch 4 oder 5,
**dadurch gekennzeichnet,**
**dass** der weitere Sensor (9) dazu ausgebildet ist, eine Verformung oder Bewegung der Blende (6) beim Eindrücken und eine entgegengesetzte Bewegung oder Verformung der Blende (6) beim Loslassen zu erfassen und der Steuereinrichtung (4) als Signal zuzuführen zur Bestimmung des Bedienereignisses.

12. Bedienvorrichtung (5) nach Anspruch 4 oder 5,
**dadurch gekennzeichnet,**
**dass** der Kraftsensor (9) oder Wegsensor rückseitig im mittleren Bereich mit der Blende (6) gekoppelt oder befestigt ist, bezogen auf die Erstreckung der Blende von einem seitlichen Ende (61) zum gegenüberliegendem seitlichen Ende (62).

13. Bedienvorrichtung (5) nach einem der Ansprüche 1 bis 12,
**dadurch gekennzeichnet,**
**dass** der Aktor (18) rückseitig an einem seitlichen Ende (61) der Blende (6) und ein weiterer Aktor (18) rückseitig am gegenüberliegenden, seitlichen Ende (62) der Blende (6) gekoppelt oder befestigt ist.

14. Bedienvorrichtung (5) nach einem der Ansprüche 1 bis 13,
**gekennzeichnet durch**
ein akustisches Ausgabemittel welches dazu ausgebildet ist, ein akustisches Signal im erfassten Betätigungsfall auszugeben.

15. Sensor-Aktor Modul (19) geeignet zum Einsatz in einer Bedienblende nach einem der Ansprüche 2 bis 14, ausgebildet, als modulare Einheit ausgebildet, umfassend ein Gehäuse (19), ausgebildet zur Befestigung an der Blende (6) oder dem Gehäuse (2) des Gerätes und einem Mittel (23, 20) zur Übertragung der Bewegung zwischen Blende (6) und Sensor-Aktor-Modul (19).

16. Sensor-Aktor Modul (19) nach Anspruch 15,
**dadurch gekennzeichnet,**
**dass** der Aktor (18) einen Elektromagneten (21) mit einem Hubanker (20) umfasst, und ferner einen mit dem Hubanker (20) gekoppelten Kraft- oder Wegsensor (9, 91, 92) zur Erfassung einer auf den Hubanker (20) eingekoppelten Bewegung, Kraft oder Druck besitzt.

17. Bedienvorrichtung nach einem der Ansprüche 2 bis 13, umfassend ein Sensor-Aktor-Modul (19) gemäß einem der Ansprüche 14 bis 15

18. Elektrisches Gerät (1), wie Gargerät (1), Getränkebereiter, Waschmaschine, Trockner, Geschirrspüler oder Desinfektionsgerät, umfassend eine Bedieneinrichtung (5) nach einem der Ansprüche 1 bis 13 oder 16, die mit einer Steuereinrichtung (4) in Wirkverbindung steht zur Einstellung und zum Betreiben des elektrischen Gerätes (1).
